Europäisches Patentamt

European Patent Office

Office européen des brevets

(11) Publication number : **0 481 741 A2**

(19)

(12) # EUROPEAN PATENT APPLICATION

(21) Application number : 91309507.1

(22) Date of filing : 10.10.91

(51) Int. Cl.⁵ : **H03F 3/193**, H03F 1/02, H03F 3/24

(30) Priority : **18.10.90 JP 280722/90**
**19.07.91 JP 204897/91**

(43) Date of publication of application :
**22.04.92 Bulletin 92/17**

(84) Designated Contracting States :
**DE FR GB IT**

(71) Applicant : **HITACHI, LTD.**
**6, Kanda Surugadai 4-chome**
**Chiyoda-ku, Tokyo 101 (JP)**
(71) Applicant : **HITACHI TOHBU**
**SEMICONDUCTOR LTD.**
**15, Oh-aza Asahidai Moroyama-machi**
**Iruma-gun Saitama (JP)**

(72) Inventor : **Toba, Yoshitomi**
**6-9-2 Tamadaira**
**Hino-shi, Tokyo (JP)**
Inventor : **Adachi, Tetsuaki**
**62-16 Shigeno-tosu, Tohbu-machi**
**Chiisagata-gun, Nagano (JP)**
Inventor : **Masuda, Akira**
**4-3-9 Annaka, Annaka-shi**
**Gunma (JP)**
Inventor : **Yamada, Shinji**
**206 Fukutomimanshon, 716-2**
**Kaminakai-machi**
**Takasaki-shi, Gunma (JP)**
Inventor : **Itou, Mamoru**
**1151-3 Oh-aza Shimoshinden,**
**Tamamura-machi**
**Sawa-gun, Gunma (JP)**

(74) Representative : **Calderbank, Thomas Roger et al**
**MEWBURN ELLIS 2 Cursitor Street**
**London EC4A 1BQ (GB)**

(54) **High frequency power amplifier circuit and mobile radio communication apparatus using the same.**

(57) Amplifying elements of a final stage circuit are biased in definite voltage, and amplifying elements of a drive circuit are biased in variable voltage. Then amplifying elements of the final stage circuit are operated at the operation point to enable the class "AB" amplification where the power efficiency and the linearity are compatible, and bias of amplifying elements of the drive circuit is made variable thereby the power gain may be varied at a wide range. The high frequency power amplifier circuit is constituted by multiple stages comprising the final stage circuit and the drive circuit, and amplifying elements of the final stage circuit are constituted by GaAs FET and amplifying elements of the drive circuit are constituted by enhancement type MOS transistor, so that even in super high frequency band of quasi SHF class, while the good amplification characteristics and the power efficiency are secured, the high frequency output power can be variably controlled in a wide range using system capable of being realized simply. Accordingly, without controlling the bias voltage having opposite polarity of the operation source voltage, the power gain of the whole high frequency power amplifier circuit can be varied in a wide range.

FIG. 1

EP 0 481 741 A2

The present invention relates to effective technology to be applied to a high frequency power amplifier circuit and further to a radio transmitter in which high frequency signals subjected to low power modulation are power-amplified and outputted to an antenna, for example, to effective technology to be utilized in mobile radio communication apparatuses such as a car telephone, a cordless telephone or the like, using radio waves in super high frequency bands of UHF (Ultra High Frequency) or SHF (Super High Frequency) or more.

In general, a high frequency power amplifier circuit to be used in a transmission unit of a radio communication apparatus is constituted by multiple stages comprising a pre-drive circuit and a final stage circuit driven by the pre-drive circuit so that a high frequency input signal subjected to low power modulation is amplified to a necessary power level. The pre-drive circuit and the final stage circuit are constituted respectively by a GaAs FET (gallium arsenide field effect transistor) formed on a semi-insulating gallium arsenide (GaAs) substrate for example, and constituted as independent semiconductor chips. The respective independent semiconductor chips are installed, for example, on a module substrate such as a ceramic substrate on which prescribed wiring is previously formed, and constitute a high frequency power amplification module (hereinafter referred to as "power module"). A power module installing the plurality of GaAs FET chips thereon is described, for example, in "National Technical Report" Vol. 36, No. 4, Aug. 1990, pp. 414 - 418. Also in recent years, in the field of radio communication apparatuses, particularly in the field of portable telephones, attention is attracted to technology of Automatic Power Control (hereinafter referred to as "APC") where transmission output of the power module incorporated in the radio communication apparatus is automatically controlled. The APC is a mechanism where it is noticed that required transmission power is different depending on, for example, length of the communication distance or the communication environment (state), and, for example, when the communication distance is long, the communication power is made large, and when the communication distance is short, the transmission power is made small, and the automatic control is carried out so as to obtain the optimum transmission power, and the power saving is intended.

That is, in the case of the mobile communication apparatus which is linked to a subscriber telephone network through a base station installed per each region, electric field strength of a radio signal from the communication destination side being oscillated from the corresponding base station is detected. Decision is effected as to the distance between speakers (or the communication state) depending on whether the detected electric field strength is large or not, and in turn, the detected signal is fed back as control signal to a power control circuit of the transmission unit (power module). Thereby the gain adjustment of the power module is carried out, and the transmission power is optimized. A radio communication apparatus having a power module controlled by the above-mentioned APC mechanism is described, for example, in "1990 National Conference Record of the Institute of Electrical and Information Engineers of Japan" (held on 28th - 30th, August, 1990), "S22, Present State and Trend of Portable Telephone Miniaturized Circuit Technology" by Y. Hirano of Fujitsu Co., Ltd.

US patent relating to a portable radio transceiver is disclosed in the United States Patent 4,636,741.

An object of the present invention is to provide transmission control technology where good linear characteristics and the power efficiency can be secured stably and the high frequency output can be variably controlled in a wide range.

Another object of the present invention is to provide technology where miniaturization of a power module and a radio communication apparatus including a power module, the power saving, and the operation in high frequency can be intended.

The foregoing and other objects and novel features of the present invention will become apparent from the description of the specification and the accompanying drawings.

Outline of the typical invention among those disclosed in the present patent application will be described as follows.

In a high frequency power amplifier circuit in multistage constitution having a final stage circuit using MOSFET or GaAs FET as a power amplifying element, and a drive circuit for linearly amplifying high frequency signals subjected to low power modulation and for driving the final stage circuit, bias condition of the final stage circuit coupled with an output terminal of the amplifier circuit is held constant by a fixed bias means, and bias condition of the drive circuit coupled with an input terminal of the amplifier circuit is varied by a variable bias means thereby the variable control of the high frequency output power is carried out.

More preferably, the bias point is determined fixedly so that the amplifying element of the final stage circuit performs the class "AB" amplification.

According to the above-mentioned means, while the operating condition of the final state circuit affecting significantly both the linear characteristics and the power efficiency is held constant, the power gain of the high frequency amplifier circuit as a whole can be varied.

Thereby he foregoing objects can be attained in that while the good linear characteristics and the power efficiency are secured stably, the high frequency output can be variably controlled in a wide range.

Also a high frequency power amplifier circuit is constituted by multiple stages comprising a final stage circuit and a drive circuit for driving the final stage circuit, and an amplifying element of the final stage circuit is constituted by GaAs FET of high efficiency and an amplifying element of the drive circuit is constituted by silicon MOSFET of enhancement type with good control property.

According to the above-mentioned means, since the silicon MOSFET of enhancement type of the drive circuit is operated by positive bias voltage having the same polarity as that of the operation source voltage thereby the positive bias voltage is variably operated and output of the drive circuit is variably controlled, even if the operation source voltage of GaAs FET of the final stage circuit and the negative bias voltage are not variably controlled, the power gain of the high frequency power amplifier circuit as a whole can be varied in a wide range.

Further, in the drive circuit having the silicon MOSFET as an amplifying element, although the power efficiency in the high frequency band becomes low in comparison to the final stage circuit of the GaAs FET, as the power level treated by the drive circuit is relatively low, influence of the power efficiency of the drive circuit given to the power efficiency of the whole circuit is little.

Thus since a new element for variably controlling the operation source voltage and the negative bias is not necessary, the high frequency power amplifier circuit (power module) can be miniaturized, and while the good amplification characteristics and the power efficiency are secured even in the high frequency band, the high frequency output power can be variably controlled in a wide range.

In the drawings

FIG. 1 is a schematic constitution diagram of a mobile radio communication apparatus as an embodiment of the invention;

FIG. 2 is a waveform chart of an output signal;

FIG. 3 is a schematic diagram illustrating classification of an amplifier by bias condition;

FIG. 4 is a schematic constitution diagram of a mobile radio communication apparatus as another embodiment of the invention;

FIG. 5 is a schematic constitution diagram of a high frequency power amplifier circuit as another embodiment of the invention;

FIG. 6 is a schematic constitution diagram of a high frequency power amplifier circuit as another embodiment of the invention;

FIG. 7 is a schematic constitution diagram of a high frequency power amplifier circuit as another embodiment of the invention;

FIG. 8 is a diagram showing an embodiment of a high frequency power amplifier circuit of the invention;

FIG. 9 is a diagram showing another embodiment of a radio communication apparatus using a high frequency power amplifier circuit of the invention;

FIG. 10 is a diagram showing another embodiment of a radio communication apparatus using a high frequency power amplifier circuit of the invention;

FIG. 11 is a diagram showing another embodiment of a radio communication apparatus using a high frequency power amplifier circuit of the invention;

FIG. 12 is a device sectional view of silicon MOSFET constituting a high frequency power amplifier circuit of the invention;

FIG. 13 is a device sectional view of GaAs FET constituting a high frequency power amplifier circuit of the invention; and

FIG. 14 is a module plan view of a high frequency power amplifier circuit in hybrid integration of the invention.

Before the description of the present invention, the problems which have been made clear by the present inventors will be described.

In a high frequency power amplifier circuit (power module) used in a radio communication apparatus, in order that high frequency signals subjected to low power modulation in modulation systems, for example, four-phase differential PSK (Differential Phase Shift Keying) or SSB (Single Side Band) or AM (Amplitude Modulation) are power-amplified without distortion, prescribed linear characteristics are required. Further, in a mobile radio communication apparatus having a battery as a power source, high power efficiency is required in order to decrease the power consumption.

The linear characteristics and the power efficiency depend on the operation characteristics of the final stage circuit. Further the operation characteristics of the final stage circuit are determined mainly by the bias condition and the source voltage. Therefore in the high frequency power amplifier circuit, in order to make the linear characteristics and the power efficiency compatible with each other, it is preferable for the final stage circuit to operate in the class "AB".

It has been found, however, that the operation range of the class "AB" to make the linear characteristics and the power efficiency compatible is narrow, and even slight change of the bias condition causes significant deterioration of the linear characteristics or significant decrease of the power efficiency.

Consequently, in a high frequency power amplifier circuit in the prior art where the bias voltage of the final stage circuit is varied according to the APC technology thereby the high frequency output power is variably controlled, a problem has been found in that the variable control of the output voltage is accompanied by the significant deterioration of the linear characteristics of the final stage circuit or the significant decrease of the power efficiency of the final stage circuit.

Also as another means, in order to perform variable control of the high frequency output power of the high frequency power amplifier circuit according to the APC technology, the source voltage $Vdd_1$ of the final stage circuit and the source voltage $Vdd_2$ of the pre-drive circuit are separated, and the source voltage $Vdd_1$ of the final stage circuit is varied. In this case, however, since the operation characteristics of the final stage circuit are varied significantly, the linear characteristics of the final stage circuit may be deteriorated or the power efficiency of the final stage circuit may be decreased. It has been found that this tendency becomes conspicuous particularly when GaAs FET or MOSFET is used as a power amplifying element.

Further, as a result of the stud by the present inventors regarding further power saving and miniaturization in the power module and a radio communication apparatus having the power module, problems have been made clear as follows.

In the prior art, the APC technology is adopted to intend the power saving, and the source voltage of the power module is varied thereby the output power is controlled. In other words, drain voltage supplied to drain of GaAs FET constituting the power module is varied thereby the output power is controlled. Consequently, a variable resistor to vary the source voltage is necessary, and since the power loss is large at the variable resistor, sufficient power saving cannot be achieved. A switching power source may be used for the countermeasure without using the variable resistor. In this case, however, a separate power transistor is necessary as a switching element thereby the miniaturization of the power module is obstructed. Further, when the operation frequency of the switching element is close to the frequency used by the radio communication apparatus, the disturbance wave may be generated due to the switching of the power source and the communication state may be deteriorated.

As another method of controlling the output power of the power module, voltage applied to gate (gate bias) of the GaAs FET constituting the power module ma be variably controlled. However, since the GaAs FET is a device of depletion type, that is, the GaAs FET is normally ON when the gate bias is in the state of O[V], negative gate bias is necessary to control the output power. If it is fixed negative bias only, for example, using a diode and a capacitor, the negative bias can be generated from a positive pulse power source relatively easily. However, in order that bias of both positive and negative polarities is variably controlled smoothly, the bias control circuit is complicated (for example, the number of component elements of the bias control circuit is increased), and the miniaturization of the power module is obstructed.

From now on, in the field of the radio communication apparatuses such as the portable telephone, request will become further strong for the miniaturization and the power saving of the apparatus including the power module, as well as for the high speed operation (high frequency operation) of the signal processing in the power module with multiple functions or in the apparatus including the power module.

Preferred embodiments of the present invention will be described based on the accompanying drawings as follows.

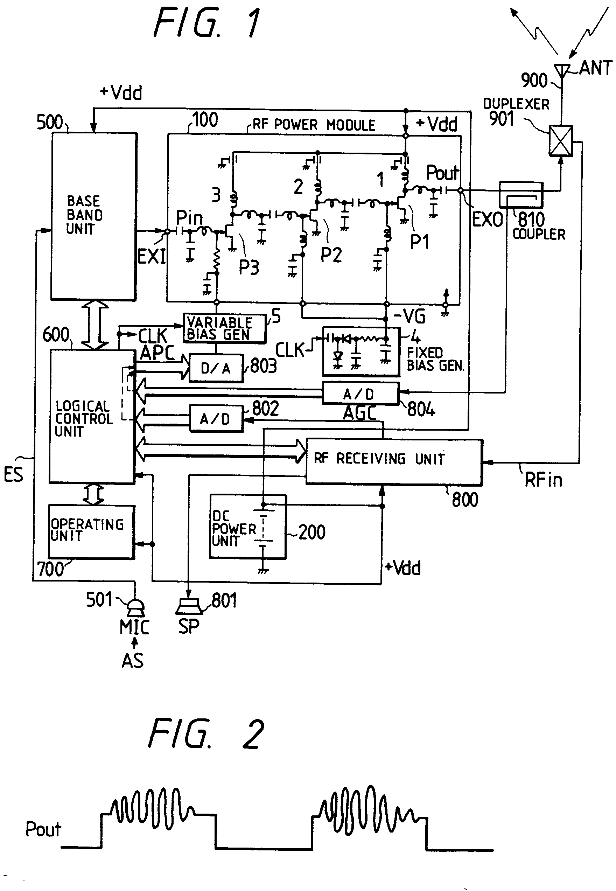

FIG. 1 is a block diagram of a mobile radio communication apparatus, such as a car telephone, a cordless telephone or the like, to which the present invention is applied.

The mobile radio communication apparatus comprises a microphone 501 for converting audio signals (AS) to be transmitted into electric signals (ES), a radio signal generating unit (base band unit) 500 for digital-modulating the converted electric signals, a high frequency power amplifier circuit (RF power module) 100 for receiving the digital-modulated radio signals (Pin) at an input terminal EXI, for power-amplifying the received signals and for outputting the amplified signals from an output terminal EXO, and a transmitting/receiving antenna 900 to which the power-amplified radio signals (Pout) as shown in FIG. 2 are fed through an antenna connection unit (duplexer) 901.

The mobile radio communication apparatus further comprises an RF receiving unit 800 for receiving the digital-modulated reception radio waves (RFin) received by the antenna 900 through the duplexer 901 and for demodulating the reception radio waves, and a speaker 801 for reproducing the demodulated signals from the RF receiving unit 800 into voice signals and various tones.

The base band unit 500 generates high frequency signals (Pin) where the inputted signals are subjected to the low power modulation by digital modulation systems, such as poly-phase PSK (phase shift keying), SSB (single side band), AM (amplitude modulation) or the like. For example, frequency of the high frequency signals (Pin) is made values of 920 MHz - 945 MHz. That is, the high frequency power amplifier circuit 100 is deemed as a narrow band power amplifier.

In FIG. 1, numeral 200 designates a DC power unit using a secondary battery such as Ni-Cd cell for generating the source voltage +Vdd, such as 12V or 6V, numeral 4 designates a fixed bias circuit, numeral 5 designates a variable bias circuit, numeral 600 designates a logical control unit using a microcomputer, and numeral 700 designates an operating unit having a key switch, an indicator and the like.

The high frequency power amplifier circuit 100 as shown by its equivalent circuit in FIG. 1, comprises a final stage circuit 1 by GaAs FET (P1) and drive circuits 2, 3 by GaAs FETs (P2, P3), being moduled as a hybrid integrated circuit. The amplified output Pout of the high frequency power amplifier circuit 100 is variably controlled by negative bias voltage -VG outputted by the variable bias circuit 5, and the variable bias circuit 5 is controlled based on power control signal APC from the logical control unit 600. The logical control unit 600 controls the variable bias circuit 5 so that the transmission power of the radio communication apparatus becomes proper level without excess or deficiency in response to the communication state. For example, the transmission output in the case of a car telephone is varied between 6W - 1W.

In FIG. 1, the fixed bias circuit 4 is constituted by a negative bias generator comprising a diode and a capacitor. Reference clock CLK to be used in the logical control unit 600 is used as input power source of the negative voltage generator. The reference clock CLK is a positive pulse signal of definite period, and definite negative bias voltage -VG is supplied stably to gates of the GaAs FETs (P1, P2) of the final stage circuit 1 and the drive circuit 2.

The variable bias circuit 5 is controlled by output of a D/A converter 803. The D/A converter 803 performs analog conversion of the power control signal APC outputted in form of digital code data by the logical control unit 600, and the variable bias circuit 5 is controlled by the converted output of the D/A converter 803 and the bias voltage -VG is supplied to the pre-drive circuit 3. In addition, the variable bias circuit 5 may be constituted by a circuit adopted in the fixed bias circuit 4 and an operational amplifier or the like.

AGC signal (AGC) in response to the strength of the received radio wave is taken from the RF receiving unit 800. The AGC signal is digitized by an A/D converter 802, and then read in the logical control unit 600.

Thereby the logical control unit 600 operates the gate bias voltage -VG of the GaAs FET (P3) of the pre-drive circuit 3 based on the strength of the received radio wave, and performs the optimization control of the radio transmission power.

As seen from FIG. 1, a coupler 810 is installed at the output of the RF power module 100, and monitoring of the transmission power is enabled. That is, the analog output of the coupler 810 is digital converted by the A/D converter 804, and is read in the logical control unit 600. As a result, since the logical control unit 600 can know the substantial transmission power from the digital data of the A/D converter 804, the transmission power can be controlled with high accuracy by the high accuracy control of the APC signal. In addition, the monitoring of the transmission power is effective also in preventing breakage of elements of the GaAs FET (P1) in the final stage circuit 1.

The fixed bias circuit 4 generates voltage of about -1V, for example, when the GaAs FETs (P1, P2) have the threshold voltage of -1.5V, and the GaAs FETs (P1, P2) are operated at the operating point of the class "AB" where the linear characteristics and the power efficiency are compatible.

On the other hand, the variable bias circuit 5 is controlled so as to vary gate bias of GaAs FET (P3) in range of -2.0V - 0V, for example, when the threshold value of the GaAs FET (P3) is -1.5V.

Next, operation will be described.

High frequency signals Pin of low power modulated in amplitude or phase by the radio signal generating unit 500 are amplified in sequence in the pre-drive circuit 3 and the drive circuit 2 and then power-amplified in the final stage circuit 1, and the amplified high frequency outputs Pout are fed to the antenna 900 and radiated in the air.

In this case, if the bias voltage -VG of the pre-drive circuit 3 is varied by the control signal (APC signal), the amplification characteristics in the pre-drive circuit 3 are varied, and the amplitude level of the high frequency signals inputted from the drive circuit 2 to the final stage circuit 1 is varied. The high frequency signals with the amplitude level varied in the pre-drive circuit 3 are inputted from the drive circuit 2 to the final stage circuit 1 and power-amplified. Then since the final stage circuit 1 is fixedly set by the fixed bias circuit 4 so that the class "AB" operation with the high linear characteristics and the high power efficiency is carried out, the amplitude level of the high frequency signals varied in the pre-drive circuit 3 is reflected with fidelity to the amplitude level of the power amplified outputs. That is, the bias condition of the pre-drive circuit 3 is varied by the APC signal, thereby while the bias condition of the final stage circuit 1 is held constant, the power gain of the high frequency power amplifier circuit as a whole is varied.

On the other hand, in the pre-drive circuit 3, the bias condition is varied thereby the power efficiency is significantly varied. However, being different from the final stage circuit 1 occupying most of the consumption power, influence of the power efficiency of the pre-drive circuit 3 giving to the whole consumption power is little. Also in the pre-drive circuit 3, the bias condition is varied thereby the linear characteristics are deteriorated. However, signals treated by the pre-drive circuit 3 are at low power, and the dynamic range is small. Consequently in the pre-drive circuit 3, being different from the final stage circuit 1 to treat signals with the large dynamic range, influence of the deterioration of the linear characteristics due to the variation of the bias condition is little.

Thereby while the operating condition of the final stage circuit 1 affecting significantly both the linear characteristics and the power efficiency is held to the optimum state, the power gain of the high frequency amplifier circuit as a whole can be varied. Consequently, while the good linear characteristics and the power efficiency are secured stably, the high frequency output power can be variably controlled in a wide range.

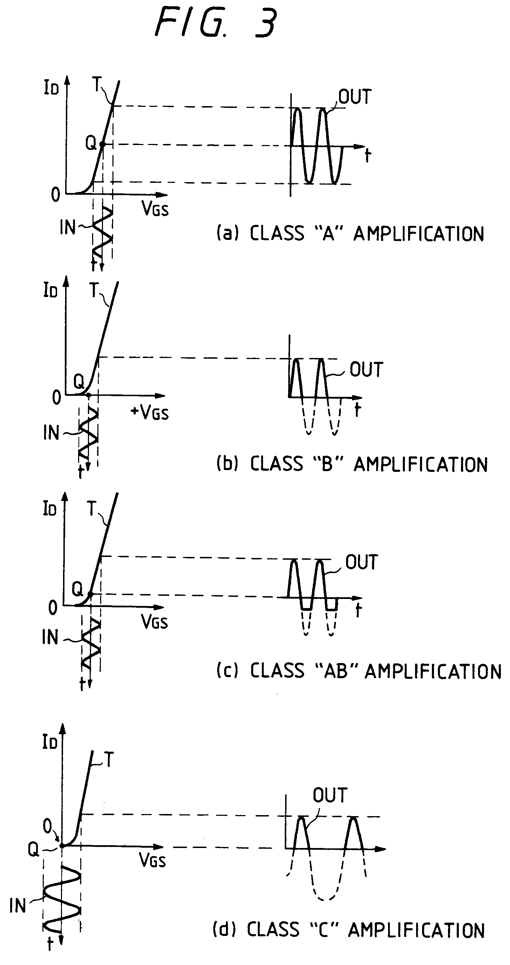

FIG. 3 (a) to (d) schematically shows classification of the power amplifier circuits depending on the bias conditions. In each figure, $I_D$ designates drain current, $V_{GS}$ designates gate-source voltage, in designates input signal, out designates output signal, t designates time, Q designates bias point, and T designates transfer curve of an amplifying element (GaAs FET) respectively.

As seen from FIG. 3, in the case of the class "A" amplification (FIG. 3(a)), since the bias point Q is set to nearly the middle point of the transfer curve T, drain current flows through the full period of input sinusoidal wave and therefore the power efficiency is bad.

In the case of the class "B" amplification (FIG. 3(b)), the bias point Q is set so that the drain current $I_D$ flows little at the non-signal state, and the design is carried out so that the drain current $I_D$ flows by just a half cycle when sinusoidal wave signal is applied. Consequently, the power efficiency is good in comparison to the class "A" amplification, but the linearity is deteriorated. For example, cross-over distortion is generated.

In the case of the class "AB" amplification (FIG. 3(c)), the bias point Q is set so that the drain current $I_D$ becomes more than that of the class "B" amplification at the non-signal state, and the drain current $I_D$ flows through a half cycle or more with respect to the input sinusoidal wave. Consequently, it is called the class "AB" amplification in the meaning of intermediate state between the class "A" amplification and the class "B" amplification. Consequently, the bias point Q is set to the point where the power efficiency and the linearity are compatible.

In the case of the class "C" amplification (FIG. 3(d)), the bias point Q is set so that the drain current $I_D$ does not flow at the non-signal state, and the drain current $I_D$ flows through a half cycle or less with respect to the input sinusoidal wave. The power efficiency is the highest, and this is utilized in the high frequency amplification.

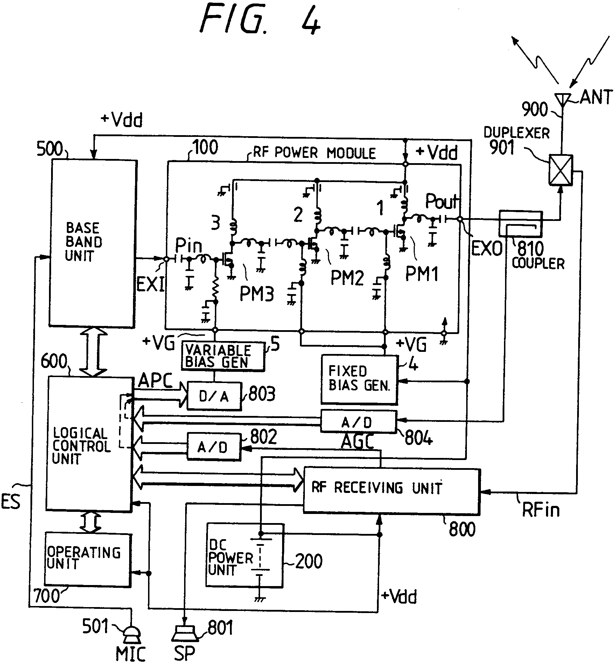

FIG. 4 shows a mobile radio communication apparatus of the present invention in the case of using MOSFETs (PM1 - PM3) as amplifying elements.

Parts different from those of FIG. 1 will be described as follows.

Since enhancement type MOSFETs (PM1, PM2, PM3) are utilized as amplifying elements of the RF power module 100, the bias potential of each MOSFET (PM1 - PM3) is made positive potential +VG. For example, voltage supplied from the fixed bias circuit 4 to gates of respective MOSFETs (PM1, PM2) of the final stage circuit 1 and the drive circuit 2 is made +1.5V, if the threshold voltage of the MOSFETs (PM1, PM2) is made +1V. On the other hand, voltage supplied from the variable bias circuit 5 to gate of MOSFET (PM3) of the pre-drive circuit 3 is made variable in range of 0V - +2.5V, if the threshold voltage of the MOSFET (PM3) is made +1V.

Consequently, the bias circuits 4, 5 may be constituted by utilizing an operational amplifier.

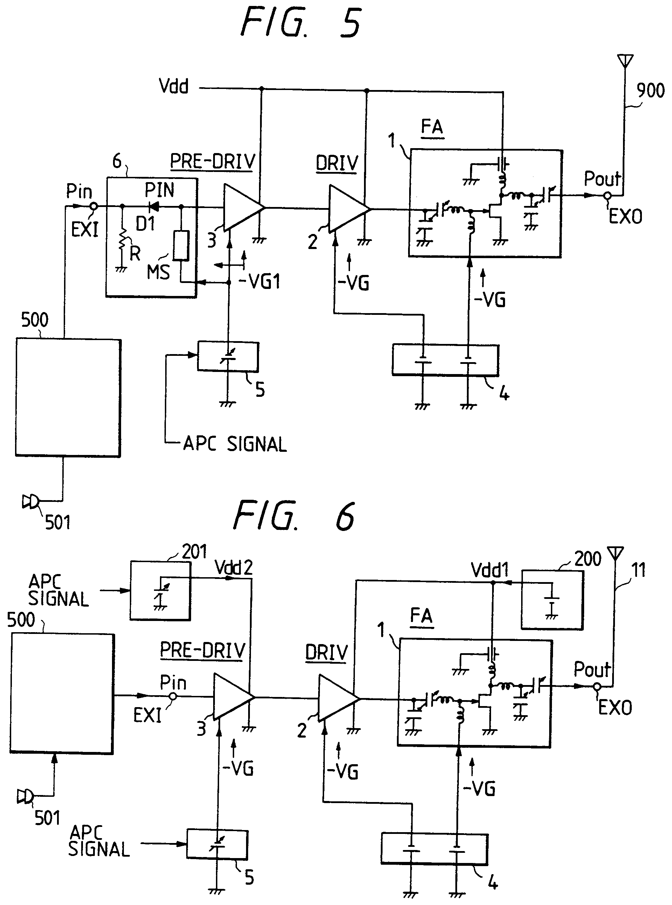

FIG. 5 shows schematic constitution of a high frequency power amplifier circuit according to another embodiment of the present invention.

Describing this noticing difference from the embodiment in FIG. 1, the embodiment of FIG. 5 comprises a variable attenuator 6 which is controlled by the output voltage -VG1 of the variable bias circuit 5 varying the bias condition of the pre-drive circuit 3, and attenuates the input level of the pre-drive circuit 3 in response to the control signal (APC signal). Thereby the power variable range of the high frequency output Pin by the control signal (APC signal) can be further extended. The variable attenuator is constituted using a PIN diode D1, a resistor R and a micro strip line MS as shown in FIG. 5.

FIG. 6 shows schematic constitution of a high frequency power amplifier circuit according to another embodiment of the present invention.

In the embodiment of FIG. 6, in addition to constitution of the embodiment of FIG. 1, constitution is added in that operation source voltage Vdd1 of the final stage circuit 1 is supplied by a fixed voltage source circuit 200, and operation source voltage Vdd2 of the pre-drive circuit 3 is supplied by a variable source voltage circuit 201 which is variably controlled by the control signal (APC signal). Thereby the power variable range of the high frequency output Pin by the control signal (APC signal) can be further extended.

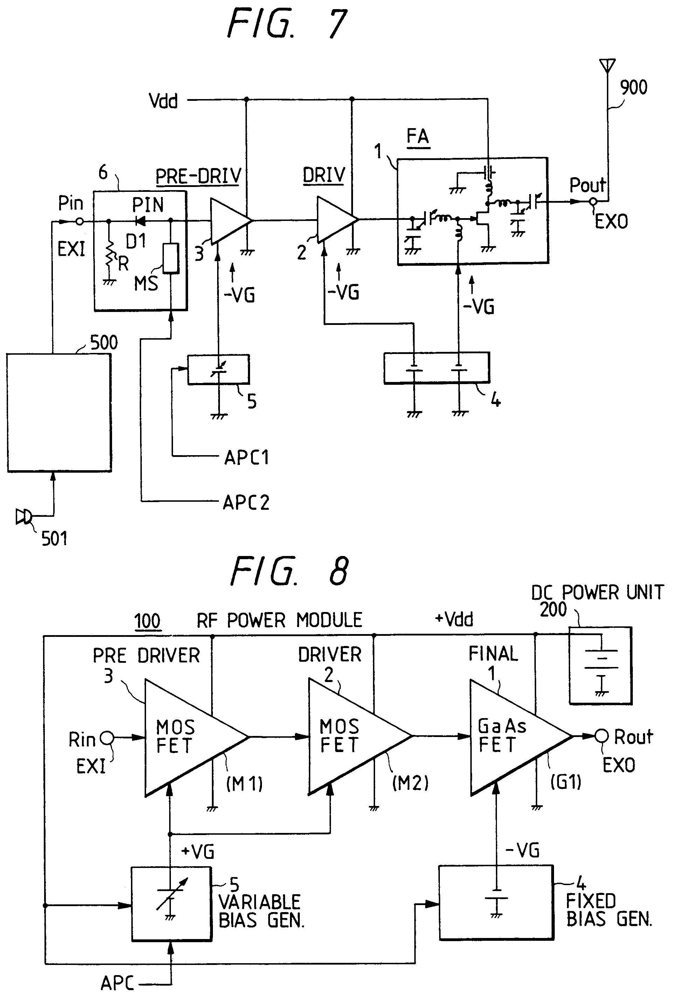

FIG. 7 shows schematic constitution of a high frequency power amplifier circuit according to another embodiment of the present invention.

In this embodiment, control signal (APC1) of the variable bias circuit 5 and control signal (APC2) of the variable attenuator 6 in the embodiment of FIG. 5 are independently supplied respectively, thereby the power variable range of the high frequency output Pin can be further extended in comparison to the case of the embodiment of FIG. 5.

That is, in the high frequency power amplifier circuit using MOSFET or GaAs FET as a power amplifying element, while the good linear characteristics and the power efficiency are secured stably, the high frequency output power can be variably controlled in a wide range.

FIG. 8 shows schematic constitution of a high frequency power amplifier circuit (power module) according to another embodiment of the present invention.

In the narrow-band high frequency power amplifier circuit shown in FIG. 8, for example, high frequency signals of 920 MHz - 945 MHz or 800 MHz - 820 MHz subjected to low power modulation are linearly amplified to necessary power and outputted to an antenna. In FIG. 8, numeral 100 designates a high frequency power amplifier circuit, numeral 200 designates a DC power unit, numeral 300 designates a fixed bias circuit, numeral 400 designates a variable bias circuit, Rin designates amplified input inputted to an input terminal EXI of the power module 100, and Rout designates amplified output outputted from an output terminal EXO of the power module 100.

The high frequency power amplifier circuit 100 is constituted by multiple stages comprising a final stage circuit 1 using GaAs FET as an amplifying element, and drive circuits 2, 3 using enhancement type silicon MOSFETs as amplifying elements. In the final stage circuit 1, the operation source voltage +Vdd to determine the operating condition and the negative bias voltage -VG are fixed to definite values respectively to perform the linear operation at the maximum efficiency. The drive circuits 2, 3 are constituted in two stages of the pre-drive circuit 3 and the drive circuit 2, and linearly amplify the high frequency signals subjected to the low power modulation. The amplified outputs are variably controlled by the positive bias voltage +VG.

The DC power unit 200 supplies the positive operation source voltage +Vdd to the whole apparatus, for example, by a Ni-Cd (nickel-cadmium) cell or the like.

The fixed bias circuit 4, although not shown in detail, generates definite negative bias voltage -VG from a positive pulse power source by a diode and a capacitor for example, and supplies the voltage -VG to gate of GaAsFETG1 of the final stage circuit 1. The positive pulse power source can be obtained from clock of a control circuit (not shown).

The variable bias circuit 5 supplies the positive bias voltage +VG variably set by the APC signal (automatic power control signal) given from the outside of the power module to gates of the MOSFETs (M1, M2) of the drive circuits 2, 3.

Next, specific operation of the power module will be described.

In the high frequency power amplifier circuit 100, the enhancement type silicon MOSFETs (M1, M2) of the drive circuits 2, 3 perform the linear amplification operation by the positive bias voltage +VG having the same polarity as that of the operation source voltage +Vdd. Outputs (power gain) of the drive circuits 2, 3 can be variably controlled by the positive bias voltage +VG applied to respective gates of the silicon MOSFETs M1, M2. By the output control in the drive circuits 2, 3, while the operation condition of the final stage circuit 1 is held to the optimum state, the power gain of the high frequency power amplifier circuit 100 as a whole can be variably controlled.

Thereby without performing the complicated and large-scale operation of controlling the operation source voltage +Vdd of GaAsFETG1 of the final stage circuit 1 and the negative bias voltage -VG, the high frequency output voltage Rout can be varied in a wide range by simple operation that the positive bias voltage +VG having the same polarity as that of the source voltage +Vdd is varied.

On the other hand, since the drive circuits 2, 3 are silicon MOSFETs, for example, the power efficiency in the frequency band of 1 GHz or more becomes low in comparison to the final stage circuit of GaAs FET. However, since the power level treated in the drive circuits 2, 3 is relatively low, influence of the power efficiency given to that of the whole circuit seems to be little.

As above described, by simple constitution of the power source and the circuit that the positive one power source (+Vdd) only is supplied as the operation power source, even in the super high frequency band of 1 GHz or more, while the good linear characteristics and the power efficiency are secured, the high frequency output power can be variably controlled in a wide range.

Device structure of the silicon MOSFETs M1, M2 and the GaAs FET G1 to constitute the power module of the present invention will be briefly described. The silicon MOSFETs M1, M2 are installed respectively on the main surface of the silicon chip comprising P+ type monocrystalline silicon substrate 1 and P type monocrystalline epitaxial layer 2 installed thereon. In this case, although only the MOSFET M1 is shown, the MOSFET M2 also has similar structure. The MOSFET M1 is mainly constituted by a gate electrode 8 arranged on the main surface of the epitaxial layer 2 through a gate insulation film 6, a source domain 3 comprising n+ type semiconductor domain installed on one side of the gate electrode 8, a low density drain domain 5 comprising n- type semiconductor domain and n+ type semiconductor domain installed on other side of the gate electrode 8 and high density drain domains 4a, 4b. A source electrode 9 and a drain electrode 10 are electrically connected to the source domain 3 and the drain domain 4a respectively. That is, the MOSFET M1 is enhancement type n-channel MOSFET. In this embodiment, as shown in FIG. 8, respective source domains 3 of the MOSFETs M1, M2 are supplied with the ground potential GND (OV) of the circuit, and the drain domain is supplied with the source voltage +Vdd, and the drain output can be variably controlled by the positive variable bias +VG applied to the gate electrode 8. Although not limited to this, the gate electrode 8 is made of molybdenum (Mo) for example, and the source and drain electrodes 9, 10 are made of aluminium, and the gate insulation film 6 and the insulation film 7 are constituted by a silicon oxide film. The source and drain domains 3, 4a, 4b, 5 are formed respectively, according to ordinary ion implantation technology or diffusion technology, by introducing n type impurity (arsenic or phosphorus) to the main surface of the silicon chip. Further, a metal electrode 11 is arranged on the rear surface of the silicon substrate 1, and connected electrically to the source electrode 9.

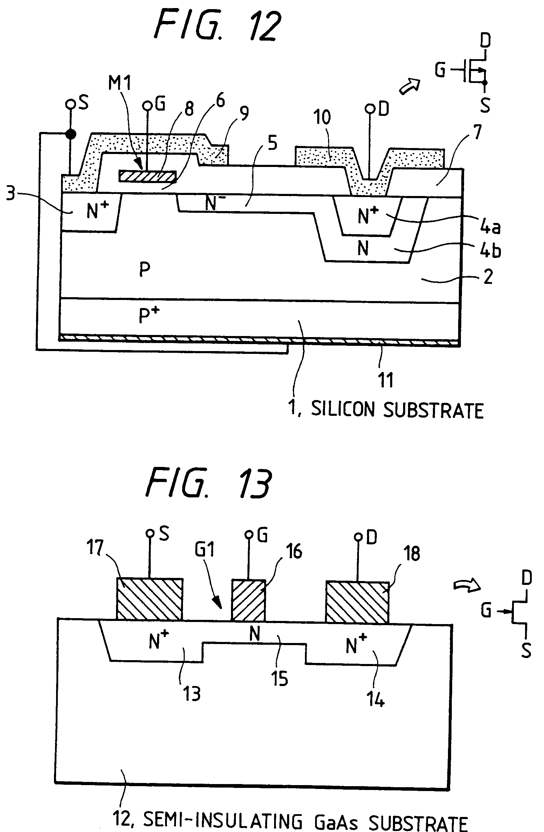

The GaAs FET G1 is installed on the main surface of a semi-insulating GaAs substrate 12 as shown in FIG. 13. The GaAs FET is mainly constituted by a gate electrode 16 made of molybdenum or aluminium, source·drain domains 13, 14 comprising n+ type semiconductor domain, and a channel domain 15 comprising n type semiconductor domain. Source-drain electrodes 17, 18 made of, for example, gold-germanium (Au-Ge) alloy, are ohmic connected to the source-drain domains 13, 14 respectively. The gate electrode 16 is directly connected onto the channel domain 15, and forms the Schottky junction. That is, the GaAs FET G1 is depletion type MOSFET. In such GaAs FET G1, since mobility of electrons within the GaAs substrate is rapid several times in comparison to that within the silicon substrate, the GaAs FET is excellent in high speed property (high frequency operation) in comparison to the silicon MOSFETs M1, M2. On the other hand, since the GaAs FET G1 is depletion type in the device structure, for the ON/OFF control or the variable control of the output voltage in a wide range, the variable gate bias having both positive and negative polarities is required. In the present invention, the fixed negative bias is applied to the gate 16 of the GaAs FET G1, and the gate bias +VG of the silicon MOSFETs M1, M2 of the front stage circuit is variably controlled, thereby variable control system of the output voltage of the GaAs FET G1 of the final stage circuit is taken. Thus since a special power supply circuit for the variable control of the negative bias is not necessary, the miniaturization of the power module can be easily achieved.

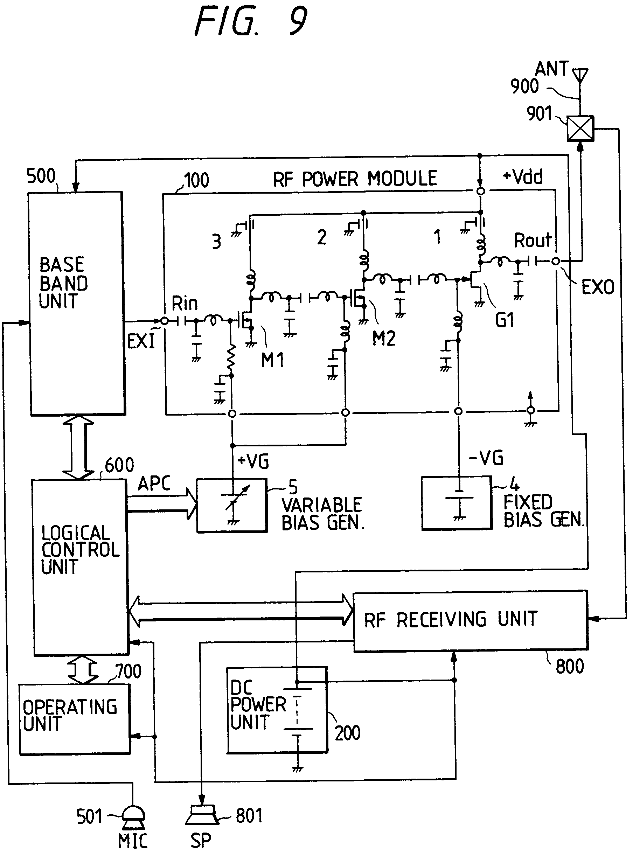

FIG. 9 shows an embodiment of a mobile radio communication apparatus using the high frequency power amplifier circuit in FIG. 8.

In FIG. 9, numeral 100 designates a high frequency power amplifier circuit as above described, numeral 200 designates a DC power unit using a secondary battery such as Ni-Cd cell, numeral 300 designates a fixed bias circuit, numeral 400 designates a variable bias circuit, numeral 500 designates a base band unit (radio signal generating unit) for generating high frequency signals (Rin) subjected to low power modulation by voice signals from a microphone 501, numeral 600 designates a logical control unit using a microcomputer, numeral 700 designates an operating unit having a key switch, an indicator and the like, numeral 800 designates an RF receiving unit, numeral 801 designates a speaker for reproducing voice and various tones, numeral 900 designates a transmitting/receiving antenna, and numeral 901 designates an antenna connection unit using a duplexer or a coaxial relay or the like.

The high frequency power amplifier circuit 100 as shown by its equivalent circuit in FIG. 9, comprises a final stage circuit 1 by GaAs FET (G1) and drive circuits 2, 3 by enhancement type silicon MOSFETs (M1, M2), being moduled as a hybrid integrated circuit. The amplified output Rout of the high frequency power amplifier circuit 100 is variably controlled by positive bias voltage +VG outputted by the variable bias circuit 5, and the variable bias circuit 5 is controlled by the power control signal APC from the logical control unit 600. The logical control unit 600 controls the variable bias circuit 5 so that the transmission power of the radio communication apparatus becomes proper level without excess or deficiency in response to the communication state.

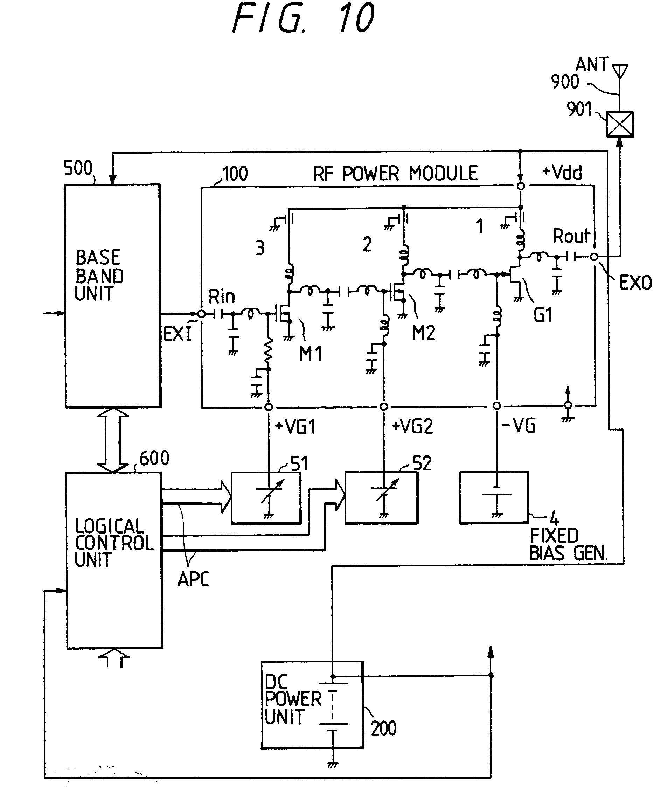

FIG. 10 shows another embodiment of a part varying the transmission power in the above-mentioned radio communication apparatus.

In the embodiment shown in FIG. 10, variable bias circuits 51, 52 are installed for a pre-drive circuit 3 and a drive circuit 2 respectively, and positive bias voltages +VG1, +VG2 outputted by respective bias circuits 51, 52 are individually controlled, thereby the power gain of the high frequency power amplifier circuit 100 as a whole can be smoothly controlled in a wide range.

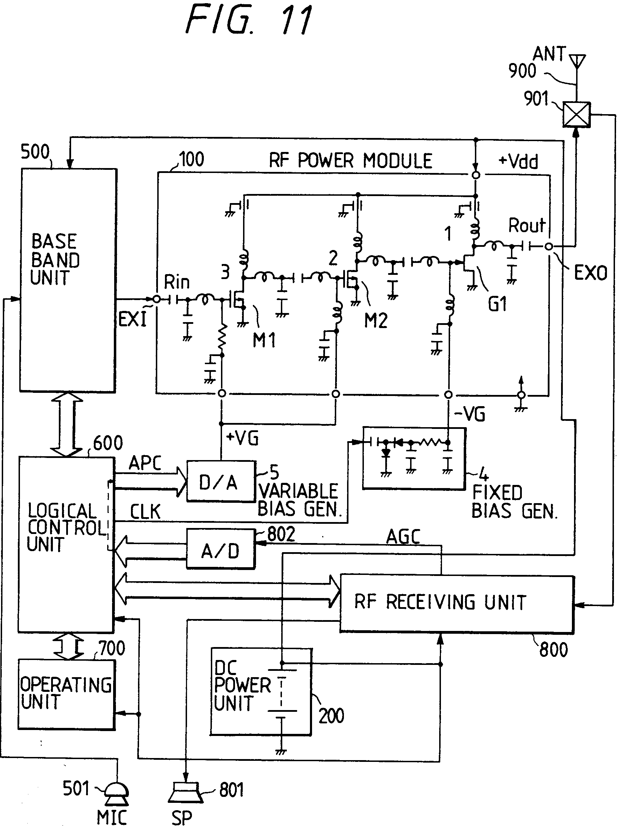

FIG. 11 shows a further detailed embodiment of the above-mentioned radio communication apparatus.

In FIG. 11, first, a fixed bias circuit 4 is constituted by a negative voltage generator comprising a diode and a capacitor, and reference clock CLK to be used in a logical control unit 600 is used as the input power source of the negative voltage generator. The reference clock CLK is a positive pulse signal of definite period, and definite negative bias voltage -VG can be supplied to gate of GaAs FET (G1) of a final stage circuit 1 stably.

A variable bias circuit 5 can be constituted by a D/A converter, and performs analog conversion of the power control signal APC outputted in form of digital code data by the logical control unit 600, and supplies the converted signal as the bias voltage +VG to the drive circuits 2, 3.

AGC signal (AGC) in response to the strength of the received radio waves can be taken from an RF receiving unit 800, and the AGC signal is digitized by an A/D converter 802 and then read in the logical control unit 600.

Thereby the logical control unit 600 operates the gate bias voltage +VG of the silicon MOSFETs (M1, M2) of the drive circuits 2, 3 based on the strength of the received radio waves, and performs the optimum control of the radio transmission power.

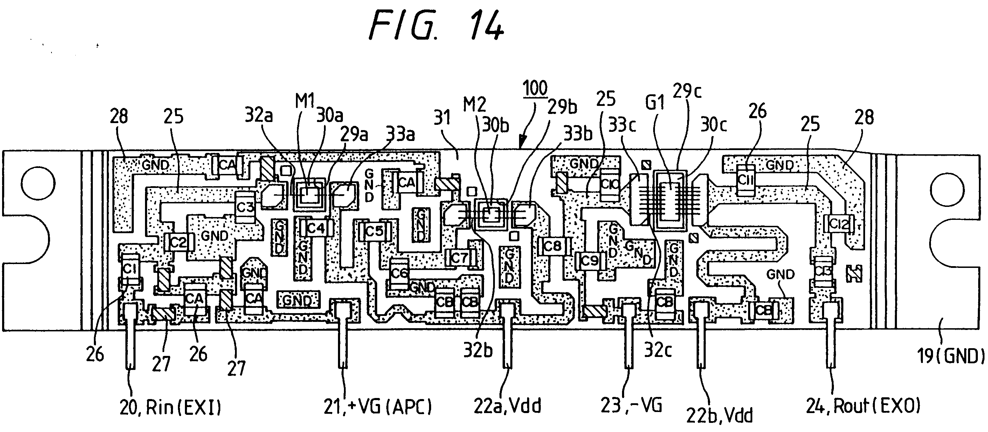

Next, an example of the above-mentioned high frequency power amplifier circuit (power module) 100 actually integrated on a module substrate will be described using FIG. 14. As shown in FIG. 14, the power module 100 is hybrid integrated on a ceramic substrate 31. On the ceramic substrate 31, a strip wiring 25, a resistor 27 and a ground wiring (GND) 28 are formed respectively by printing. Also on the ceramic substrate 31, chip capacitors 26 (C1 - C13, CA, CB) are installed, and connected to the prescribed strip wiring 25 and the ground wiring 28. At through hole portions 29a, 29b, 29c provided in the ceramic substrate 31 are installed copper heat sinks 30a, 30b, 30c respectively fixed in the through hole portions 29a, 29b, 29c, and a chip with silicon MOSFETs M1, M2 and GaAs FET G1 formed is mounted on the heat sinks 30a, 30b, 30c. The silicon MOSFETs M1, M2 and the GaAs FET G1 having the structure shown in FIGs. 12, 13 are used respectively, and each of the gate electrodes and the drain electrodes is connected by wire bonding to post tabs 33a, 33b, 33c installed on the strip wiring 25 by wires 32a, 32b, 32c of aluminium or gold. Each source electrode of the silicon MOSFETs M1, M2 is connected to a common connection conductor (not shown) arranged to the rear surface of the ceramic substrate 31 through the heat sinks 30a, 30b. Since a substrate 12 of the GaAs FET G1 is semi-insulating, the source electrode of the GaAs FET G1 is connected from the source electrode directly to the heat sink 30c by the wire bonding, thereby connected electrically to the common ground conductor. Also the ground wiring (GND) 28 is connected by the through hole printing to the common ground conductor on the rear surface of the ceramic substrate. The common ground conductor'is connected to a header 19 being a minus terminal (GND) of the DC power source. The header 19 serves also as a screwing flange to a radiating plate and a set module. Operation of the power module 100 in such constitution will be briefly described using FIG. 14 and FIG. 9 (circuit diagram). As shown in the figures, first, the high frequency power inputted from an input lead 20 (Rin) passes through a matching circuit comprising the strip wiring 25 and capacitors C1, C2, C3, and is inputted to gate of the silicon MOSFET M1. In response to the gate input, the amplified power is outputted from drain of the silicon MOSFET M1. Further, the amplified output passes through a matching circuit comprising the strip wiring 25 and chip capacitors C4, C5, C6, C7, and is inputted to gate of the silicon MOSFET M2. In response to the gate input, the amplified power is outputted from drain of the silicon MOSFET M2. Further, the amplified output passes through a matching circuit comprising the strip wiring 25 and chip capacitors C8, C9, C10, and is inputted to gate of the GaAs FET G1. In response to the gate input, the amplified power is outputted from drain of the GaAs FET G1, and finally the amplified power passes through a matching circuit comprising the strip wiring 25 and chip capacitors C11, C12, C13, and is outputted to an output lead 24 (Rout).

Also the variable bias +VG to control the high frequency output Rout is supplied from the variable bias generator 5 shown in FIG. 9 to an APC lead 21, and is inputted to gate of the silicon MOSFET M1. In this case, the structure is shown where the variable bias +VG is supplied only to gate of the silicon MOSFET M1, but the variable bias +VG can be supplied to gate of the silicon MOSFET M2 by only changing pattern of the strip line 25. The negative fixed gate bias -VG supplied to gate of the GaAs FET G1 is supplied from the fixed bias generator 300 shown in FIG. 9 to a lead 23. The DC plus power source +Vdd being the operation source voltage is supplied from the DC power unit 200 shown in FIG. 9 to leads 22a, 22b, and is supplied to each drain of the silicon MOSFETs M1, M2 and the GaAs FET G1.

Thus the power module of the present invention performs the variable control of the high frequency output in the front stage driver circuit having the silicon MOSFET, and the GaAs FET is applied to the final stage circuit most affecting the gain, thereby without necessitating the complicated circuit constitution (power source variable circuit, negative voltage variable circuit or the like), the high efficiency, the power saving and the miniaturization can be intended simultaneously.

Although the invention made by the present inventors have been described specifically based on preferred embodiments, the present invention is not limited to the embodiments but various changes and modifications may be made without departing from the spirit of the invention.

For example, the negative bias circuit 4 of GaAs FET (G1) of the final stage circuit 1 may be a self bias circuit.

The MOS transistor of the drive circuits 2, 3 in FIGs. 8 - 14 may be insulation gate type FET other than MOS, as long as it operates in enhancement mode.

In FIGs. 8 - 14, the GaAs FET G1 may be operated in the class "AB" amplification as explained in FIG. 1.

Each power module 100 of FIGs. 1 - 5,6,7 can be formed by changing MOSFETs M1, M2 in FIG. 14 to GaAs FET. Also the power module in FIG. 4 can be formed by changing GaAs FET G1 to MOSFET.

Further, the control of the transmission power may be performed by varying the output level of the input signal of the high frequency power amplifier circuit.

In the above description, the invention made by the present inventors have been mainly described in the case of application to a mobile radio communication apparatus being the utilization field as the background art, but the invention is not limited to this, but can be applied also to a radio communication apparatus for fixing.

Thus in the high frequency power amplifier circuit (power module) constituted in multiple stages using GaAs FET or MOSFET as an amplifying element, gate bias of the amplifying element (G1) for transmitting output to at least the output terminal EXO of the high frequency power amplifier circuit is made a fixed bias, and gate bias of the amplifying element (G3 or M1) supplied with input from the input terminal (EXI) of the high frequency power amplifier circuit is variably controlled.

In the above-mentioned constitution, when GaAs FET only is used as amplifying element (FIG. 1) or when MOSFET only is utilized (FIG. 4), the amplifying element for transmitting output to the output terminal EXO is operated by the fixed bias in the bias point to enable the class "AB" amplification where the power efficiency and the linearity are compatible, and the gate bias of the amplifying element with the input supplied from the input terminal EXI is made variable.

On the other hand, in the above-mentioned constitution, when both GaAs FET and MOSFET are used as amplifying elements (FIG. 8), GaAs FET with high efficiency is used as amplifying element fro transmitting to the output terminal EXO, and gate bias is made fixed bias and MOSFET with good control property is used as amplifying element supplied with input from the input terminal, and the gate bias is variably controlled. In this constitution, although the high efficiency property being advantage of GaAs FET is utilized effectively, since the gate bias is not made variable but is fixed, the control is not troublesome.

## Claims

1. A high frequency power amplifier circuit (100) comprising:

an input terminal (EXI) inputting high frequency input signals (Pin, Rin) subjected to low power modulation;

an output terminal (EXO) supplying high frequency output signals (Pout, Rout) being power amplified;

a drive circuit (3) connected electrically to said input terminal (EXI) for amplifying the high frequency input signals (Pin, Rin) to prescribed power, said drive circuit (3) having first amplifying elements (P3, PM3, M1) with bias condition being made variable by a control signal (APC), said prescribed power being determined by gain of said first amplifying element; and

a final stage circuit (1) connected electrically to said drive circuit (3) for outputting the high frequency output signal (Pout) in response to the signal amplified to the prescribed power, said final stage circuit (1) having second amplifying elements (P1, PM1, G1) to make the bias condition constant.

2. A high frequency power amplifier circuit as set forth in claim 1, further comprising:

a variable bias means (5) for varying bias condition of said first amplifying elements in response to the control signal (APC); and

a bias means (4) for making bias condition constant of said second amplifying elements.

3. A high frequency power amplifier circuit as set forth in claim 2, wherein said second amplifying elements are supplied with gate bias by said bias means (4) so that the class "AB" amplification is performed.

4. A high frequency power amplifier circuit as set forth in claim 3, wherein said first and second amplifying elements are GaAs FETs.

5. A high frequency power amplifier circuit as set forth in claim 3, wherein said first and second amplifying elements are MOSFETs.

6. A high frequency power amplifier circuit as set forth in one claim selected from claims 4 and 5, wherein said high frequency power amplifier circuit (100) is a narrow-band amplifier circuit.

7. A high frequency power amplifier circuit as set forth in claim 3, further comprising:

a variable attenuator for increasing/decreasing input level of said drive circuit by control signal from the outside, said variable bias means and said variable attenuator performing variable control of high frequency output power.

8. A high frequency power amplifier circuit as set forth in claim 3, further comprising:

a variable voltage source circuit for attenuating the operation source voltage of said drive circuit in response to the control signal, said variable bias means and said variable voltage source circuit performing variable control of the high frequency output power.

9. A high frequency power amplifier circuit as set forth in claim 3, wherein control signal of said variable bias means and control signal of said variable attenuator are independently supplied.

10. A mobile radio communication apparatus comprising:

an antenna (900);

an RF receiving unit (800) coupled with said antenna;

a speaker (801) coupled with said RF receiving unit;

a microphone (501);

a base band unit (600) coupled with said microphone; and

a high frequency power amplifier circuit as set forth in claim 2, having its input terminal couples with said base band unit and having its output terminal coupled with said antenna.

11. A mobile radio communication apparatus as set forth in claim 10, further comprising:

a microcomputer for transmitting control signal to said variable bias means.

12. A high frequency power amplifier circuit as set forth in claim 1, wherein said first amplifying elements are enhancement type MOSFET, and said second amplifying elements are GaAs FET.

13. A high frequency power amplifier circuit as set forth in claim 12, wherein said high frequency power amplifier circuit is a module hybrid integrated on a ceramic substrate.

14. A high frequency power amplifier circuit as set forth in claim 12, wherein said variable bias means generates positive bias voltage, and said bias generates negative bias voltage.

15. A radio communication apparatus wherein the radio communication apparatus includes the high frequency power amplifier circuit as set forth in claim 12.

16. A high frequency power amplifier circuit constituted by multiple stages comprising a final stage circuit and a drive circuit, wherein amplifying elements of said final stage circuit are GaAs FET, and amplifying element of said drive circuit are enhancement type silicon FET.

17. A high frequency power amplifier circuit comprising:
a final stage circuit using first sort of amplifying elements and being operated in amplification by positive operation source voltage and negative bias voltage;
a drive circuit using second sort of amplifying elements and being operated in amplification by positive operation source voltage and positive bias voltage;
a negative bias circuit for supplying said first sort of amplifying elements with prescribed negative bias voltage; and
a positive bias circuit for supplying said second sort of amplifying elements with positive bias voltage varying in response to signals from the outside.

18. A high frequency power amplifier circuit as set forth in claim 17, wherein said negative bias circuit is a fixed bias circuit for supplying definite negative bias voltage to amplifying elements of said final stage circuit.

19. A radio communication apparatus having a high frequency power amplifier circuit comprising a final stage circuit with amplifying elements being GaAs FET and a drive circuit with amplifying elements being enhancement type silicon FET, wherein gate bias voltage of the silicon FET of said drive circuit is varied thereby the radio transmission power is variably controlled.

20. A radio communication apparatus as set forth in claim 19, wherein gate bias voltage of the silicon FET of said drive circuit is varied based on the strength of the received radio waves thereby the radio transmission power is optimization controlled.

21. A radio communication apparatus as set forth in claim 20, wherein gate bias voltage of the silicon FET is supplied by a D/A converter.

22. A radio communication apparatus as set forth in any one of claims 19 to 21, wherein operation condition of said final stage circuit is fixed b definite operation source voltage and bias voltage.

23. A radio communication apparatus as set forth in any one of claims 19 to 22, wherein said final stage circuit and said drive circuit are linearly operated.

24. A radio communication apparatus comprising:
a high frequency power amplifier circuit having a final stage circuit with GaAs FET as amplifying elements and a drive circuit with enhancement type silicon FET as amplifying elements, said final stage circuit and said drive circuit being connected in multiple stages, for linearly amplifying high frequency signals subjected to low power modulation; and
means for controlling the transmission power by varying the output level of input signals of said high frequency power amplifier circuit.

# FIG. 1

# FIG. 2

# FIG. 3

(a) CLASS "A" AMPLIFICATION

(b) CLASS "B" AMPLIFICATION

(c) CLASS "AB" AMPLIFICATION

(d) CLASS "C" AMPLIFICATION

# FIG. 4

# FIG. 5

# FIG. 6

## FIG. 7

## FIG. 8

# FIG. 9

# FIG. 10

# FIG. 11

# FIG. 12

1, SILICON SUBSTRATE

# FIG. 13

12, SEMI-INSULATING GaAs SUBSTRATE

FIG. 14

EP 0 481 741 A2